# DEMANDE DE BREVET EUROPEEN

(11) **EP 3 671 065 A1**
(43) Date de publication de la demande: **24.06.2020**
(21) Numéro de dépôt: 19216761.7
(22) Date de dépôt: 17.12.2019
(51) Int. Cl.: F25B 21/00

(54) **DISPOSITIF DE REFROIDISSEMENT COMPRENANT UNE CERAMIQUE DE GRENAT PARAMAGNETIQUE**

(30) Priorité: 20.12.2018 FR 1873565
(71) Demandeur: Commissariat à l'énergie atomique et aux énergies alternatives, 75015 Paris (FR)
(72) Inventeur: DUVAL, Jean-Marc, 38054 GRENOBLE CEDEX 09 (FR); MARIN, Christophe, 38054 GRENOBLE CEDEX 09 (FR); PAIXAO BRASILIANO, Diego Augusto, 38054 GRENOBLE CEDEX 09 (FR); BICHAUD, Emmanuelle, 38054 GRENOBLE CEDEX 09 (FR); DURAND, Jean-Louis, 38054 GRENOBLE CEDEX 09 (FR)
(74) Mandataire: Brevalex

(57) **Abrégé**

Dispositif de refroidissement magnétique (100) comportant un élément magnétocalorique (110), l'élément magnétocalorique (110) comprenant un grenat paramagnétique, caractérisé en ce que le grenat paramagnétique est une céramique.

La céramique de grenat paramagnétique, de préférence, une densité supérieure ou égale à 90% et strictement inférieure à 100%.

La céramique de grenat paramagnétique est, de préférence, une céramique de grenat de gallium gadolinium ou une céramique de grenat de gallium ytterbium.

## Description

### DOMAINE TECHNIQUE

L'invention concerne un dispositif de refroidissement à base de céramique de grenat paramagnétique, plus particulièrement pour la cryogénie. L'invention s'applique également à des dispositifs de refroidissement pour des températures supérieures aux températures cryogéniques et en particulier pour des applications industrielles et domestiques.

### ÉTAT DE LA TECHNIQUE ANTÉRIEURE

La réfrigération magnétique est connue depuis le début du XXème siècle. L'effet frigorifique est obtenu en associant un matériau paramagnétique (dit magnétocalorique) à un champ magnétique externe variable. Lorsque le matériau subit une aimantation ou une désaimantation, sa température varie de manière conséquente. Ce type de réfrigération peut être utilisé pour la réfrigération dans toutes les gammes de températures allant de la température ambiante (environ de 250 K à 300 K) jusqu'aux températures dites cryogéniques (T<120 K) et particulièrement pour les très basses températures (T<10 K et de préférence T<5 K).

Un dispositif de refroidissement comprend un élément magnétocalorique à base d'un matériau paramagnétique (appelé « réfrigérant magnétique »), disposé au centre d'une bobine de fil conducteur, classiquement supraconductrice formant une source de champ magnétique variable, une source chaude et une source froide. La source chaude et la source froide sont classiquement séparées de l'élément magnétocalorique par des interrupteurs thermiques.

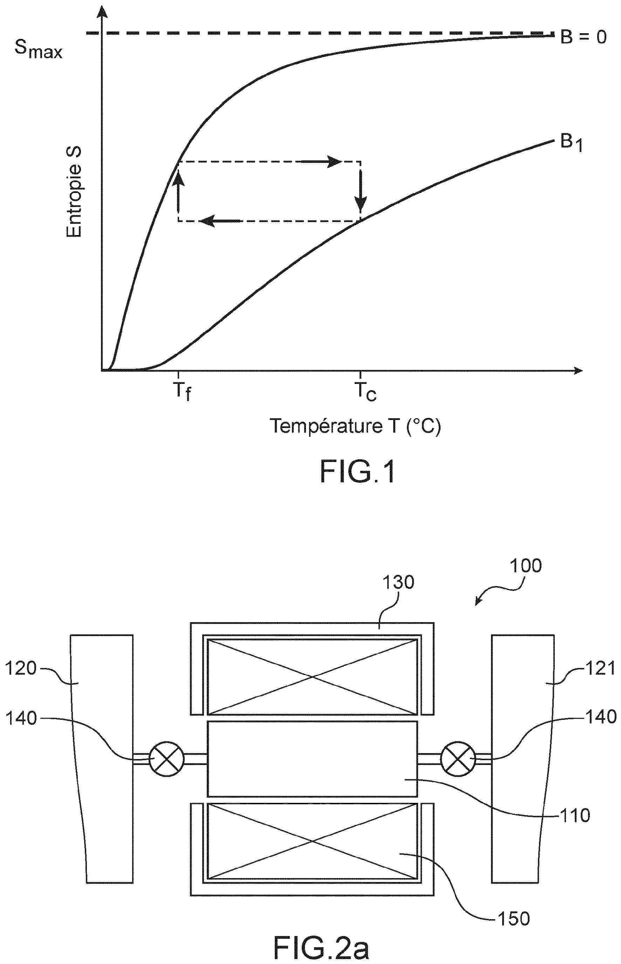

La mise en œuvre de la réfrigération magnétique se fait de manière simple et courante, aux températures cryogéniques, par un cycle de Carnot inverse (figure 1). Ce cycle classique de refroidissement comprend :
- une phase d'aimantation adiabatique puis une phase d'aimantation isotherme à la température T_{c}, pendant laquelle le champ magnétique extérieur augmente jusqu'à une valeur B₁; l'interrupteur thermique vers la source chaude est en position fermée permettant d'évacuer la chaleur,
- une phase de désaimantation adiabatique du matériau magnétique : les interrupteurs thermiques sont ouverts et le champ magnétique diminue; le matériau magnétique se refroidit jusqu'à la température de fonctionnement T_{f},
- une désaimantation isotherme, durant laquelle l'interrupteur vers la source froide est fermée de manière à mettre le matériau paramagnétique en contact avec l'élément à réfrigérer ; le champ magnétique continue à diminuer jusqu'à une valeur faible mais non nulle.

Lorsque le champ magnétique atteint sa valeur minimale, la température va remonter, puis on recommence un nouveau cycle.

Les matériaux paramagnétiques classiquement utilisés pour l'obtention de l'effet frigorifique, aux températures cryogéniques, sont les sels paramagnétiques hydratés, en particulier les aluns tel que les aluns d'ammonium ferrique (ou FAA pour « Ferric Ammonium Alum ») et les oxydes de terre rare, et en particulier les grenats, comme le grenat de gallium gadolinium Gd₃Ga₅O₁₂ (Wikus et al. « Magnetocaloric materials and the optimization of cooling power density », Cryogénies (2014), http://dx.doi.org/10.1016/j.cryogenics.2014.04.005).

Les aluns d'ammonium ferrique sont particulièrement adaptés aux températures inférieures à 1 Kelvin. Cependant, ils doivent être maintenus dans une enceinte scellée pour ne pas se déshydrater et comme ils dissolvent le cuivre, ils sont généralement utilisés avec un bus thermique en or. De plus, ils ne peuvent pas servir pour des applications où la température dépasse à un moment donné 35°C car ils se décomposent.

Par ailleurs, il est connu d'utiliser des grenats sous forme monocristalline dans des dispositifs de refroidissement. En effet, lorsqu'ils sont utilisés sous forme monocristalline, les grenats présentent une conductivité thermique qui peut être suffisante notamment à basse température, ce qui est le domaine de température où les propriétés magnétocaloriques du matériau sont les plus recherchées. Ils sont, par exemple, obtenus par un procédé de fusion de zone verticale par chauffage optique. Cependant, avec ce procédé de fabrication, il n'est pas possible d'obtenir des pièces de grandes dimensions et les coûts de fabrication sont élevés. De plus, les matériaux monocristallins sont mécaniquement fragiles et leur intégration n'est pas aisée.

Il existe donc un besoin de remplacer les matériaux magnétocaloriques existants par d'autres matériaux.

### EXPOSÉ DE L'INVENTION

Un but de la présente invention est de remédier aux inconvénients de l'art antérieur.

Pour cela, la présente invention propose un dispositif de refroidissement comportant un élément magnétocalorique, l'élément magnétocalorique comprenant une céramique de grenat paramagnétique.

L'invention se distingue fondamentalement de l'art antérieur par l'utilisation d'un grenat paramagnétique sous forme de céramique.

Par céramique, on entend les céramiques dites techniques à base d'oxydes (aussi appelées céramiques oxydes). Une céramique est un ensemble de grains partiellement coalescés. Par partiellement coalescés, on entend que certains grains sont coalescés et d'autres grains ne sont pas coalescés.

Les grains ont différentes dimensions et sont séparés par des joints de grains. Les joints de grains délimitent des zones ayant différentes orientations cristallines. Autrement dit, les orientations cristallines de deux grains, adjacents et disposés de part et d'autre d'un joint de grains, sont différentes.

Les céramiques sont des matériaux solides et denses. De préférence, la céramique a une densité supérieure à 80% et strictement inférieure à 100%. L'élaboration de la céramique nécessite pas de passer par une phase de fusion.

A titre de comparaison, un monocristal n'a pas de joint de grain et est formé d'une seule matrice d'orientation cristalline identique en tout point. Un monocristal a une densité de 100%.

Les céramiques présentent des propriétés mécaniques particulièrement élevées, et ne se clivent pas, contrairement aux monocristaux. De telles céramiques sont particulièrement avantageuses pour des applications spatiales car elles peuvent résister aux contraintes mécaniques du décollage.

Même si l'utilisation d'une céramique dans un dispositif de refroidissement paraît, à première vue, rédhibitoire en raison de sa faible conductivité thermique, due aux joints de grains de la céramique, il a été observé par le demandeur que les céramiques de grenat paramagnétique présentent néanmoins des conductivités thermiques suffisantes pour être intégré dans un dispositif de refroidissement.

Par grenat, on entend un matériau oxyde de formule générale A'₃B'₂(C'O₄)₃, et, avantageusement, un matériau de formule A'₃B'₅O₁₂ avec :
A' correspondant à une ou plusieurs terres rares, de préférence choisies parmi l'erbium, le dysprosium, l'ytterbium et/ou le gadolinium ; préférentiellement il s'agit d'ytterbium ou de gadolinium, éventuellement substitué par de l'erbium ou du dysprosium,
B' est un élément métallique, par exemple, du gallium et/ou de l'aluminium,
C' est un élément métallique, par exemple, du gallium et/ou de l'aluminium.

Selon un mode avantageux, l'élément magnétocalorique est constitué de la céramique de grenat paramagnétique.

Avantageusement, la céramique contient du gallium.

Selon une première variante avantageuse, la céramique est une céramique de grenat de gallium gadolinium. Ce grenat est aussi appelé « gadolinium gallium garnet » (GGG). Ce grenat est particulièrement intéressant pour obtenir des températures froides de 500 mK à 4 K, à partir d'une source chaude de 2 à 10 K.

Selon une deuxième variante avantageuse, le grenat est une céramique de grenat de gallium ytterbium (YbGG). Ce matériau est particulièrement adapté pour des températures froides de l'ordre de 100 mK à 1 K. Il peut être utilisé à partir d'une source chaude de 300 mK à 4 K.

Ces matériaux à base de céramique de grenat paramagnétique, notamment les GGG ou YbGG permettent d'obtenir des dispositifs de refroidissement efficace tout en étant facile d'intégration et mécaniquement résistant par rapport aux autres matériaux classiquement utilisés. En particulier, l'utilisation d'YbGG sous forme de monocristal est compliquée du fait de sa fragilité et de la difficulté de sa mise en œuvre. Il n'a donc jamais été utilisé pour la réfrigération magnétique. Selon l'invention, l'utilisation sous forme de céramique d'YbGG ou de GGG permet de réaliser facilement des pièces de grandes dimensions (par exemple de plus de 70 cm³).

Avantageusement, la céramique a une densité supérieure ou égale à 90% et strictement inférieure à 100%, et de préférence supérieure ou égale à 95% et strictement inférieure à 100%. Plus la densité de la céramique est élevée et plus la conductivité thermique sera élevée. Une densité élevée permet de maximiser l'effet frigorifique.

Avantageusement, l'élément magnétocalorique a un volume allant de 1 mm³ à 500 dm³, et de préférence, allant de 1 cm³ à 100 cm³. La mise en forme des matériaux céramiques par usinage est facilitée, ce qui permet d'obtenir des pièces de grandes dimensions et/ou de formes complexes, à moindre coût.

Un tel dispositif est particulièrement adapté pour les très basses températures (< 10 K).

Avantageusement, l'élément magnétocalorique est solidaire d'un ou plusieurs éléments métalliques. Les éléments métalliques peuvent être de même nature ou de natures différentes. Comme la céramique est un matériau particulièrement résistant mécaniquement, par rapport aux monocristaux, il est possible de fixer par collage, et de préférence, par brasage un ou plusieurs éléments métalliques sur l'élément magnétocalorique. Selon un mode de réalisation particulier, l'élément métallique, par exemple en cuivre, peut servir de bus thermique pour améliorer la conduction thermique et le fonctionnement du dispositif. Selon un autre mode de réalisation particulier, l'élément métallique, par exemple en acier inoxydable, forme une enveloppe autour de l'élément magnétocalorique, pour contenir, par exemple un fluide caloporteur à l'état liquide ou gazeux, tel que l'hélium.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
La figure 1 précédemment décrite, représente un diagramme température-entropie d'un cycle de réfrigération magnétique réalisé avec un matériau paramagnétique,
La figure 2a représente, de manière schématique, un dispositif de refroidissement, selon un mode de réalisation particulier de l'invention,
La figure 2b représente, de manière schématique, un dispositif de refroidissement, selon un autre mode de réalisation particulier de l'invention,
La figure 3 représente, de manière schématique, un dispositif de refroidissement, selon un autre mode de réalisation particulier de l'invention,
La figure 4 est un graphique représentant des courbes de température en fonction du temps, pour un dispositif de refroidissement tel que représenté à la figure 3,
Les figures 5a et 5b représentent, de manière schématique, une vue en coupe, respectivement, de profil et de dessus, d'une partie d'un dispositif de refroidissement, selon un mode de réalisation particulier de l'invention,
La figure 6 représente, de manière schématique, un dispositif de refroidissement, selon un autre mode de réalisation particulier de l'invention,
La figure 7 représente, de manière schématique, un dispositif de refroidissement, selon un autre mode de réalisation particulier de l'invention,
La figure 8 est un cliché photographique d'un barreau d'une céramique de grenat YbGG usiné, selon un mode de réalisation particulier de l'invention,
La figure 9 est un cliché, obtenu par microscopie électronique à balayage, d'une céramique de grenat YbGG, frittée à 1700°C sous air, selon un mode de réalisation particulier de l'invention.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

Par la suite, la céramique de grenat paramagnétique est décrite pour une utilisation dans un dispositif de refroidissement, plus particulièrement pour la cryogénie, et notamment dans un réfrigérateur à désaimantation adiabatique (ou ADR pour *« Adiabatic Demagnetization Refrigerator »*). L'utilisation de la céramique est particulièrement avantageuse pour des applications de 100 mK à 10 K.

La céramique de grenat paramagnétique pourrait également être utilisée pour la réfrigération magnétique à température ambiante.

La céramique de grenat paramagnétique peut également être utilisée dans un système de réfrigération magnétique active à régénération (ou AMRR pour *« Active Magnetic Regenerative Réfrigération »).*

La céramique de grenat paramagnétique peut être utilisée dans tout type de dispositif de régulation thermique.

### Dispositif de refroidissement :

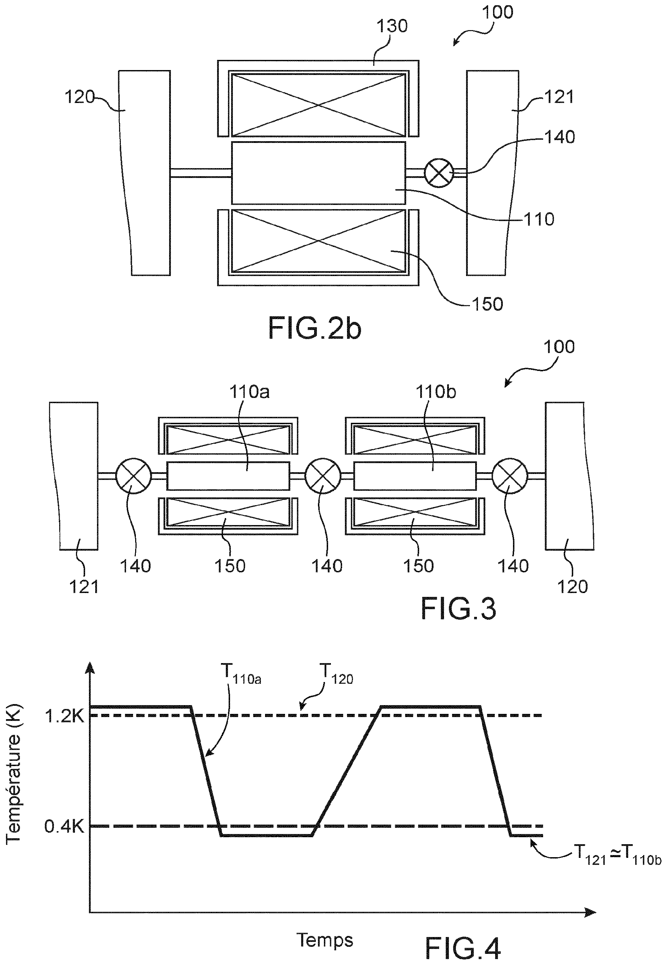

On se réfère tout d'abord aux figures 2a, 2b et 3 qui représentent des dispositifs de refroidissement 100, et plus particulièrement dans des réfrigérateurs à désaimantation adiabatique (ou ADR pour *« Adiabatic Demagnetization Refrigerator »*). Ces dispositifs magnétocaloriques 100 comprennent au moins :
- un élément paramagnétique 110, aussi appelé élément magnétocalorique,
   - une source chaude 120 et une source froide 121, l'élément paramagnétique 110 étant disposé entre la source froide 121 et la source chaude 120,
- un générateur de champ 150 conçu pour produire un champ magnétique externe.

### Elément magnétocalorique :

L'élément magnétocalorique 110 est un matériau paramagnétique. Il comprend, et de préférence est constitué, d'une céramique de grenat paramagnétique. L'utilisation d'une céramique de Grenat, et en particulier d'une céramique de grenat GGG ou de céramique de grenat YbGG, ouvre de nouvelles perspectives en raison des propriétés paramagnétiques très intéressantes de ces matériaux et de leur robustesse mécanique.

L'élément magnétocalorique 110 peut être sous forme de barreau cylindrique, de disque, ou d'une forme plus complexe.

Les dimensions de l'élément magnétocalorique 110 sont de quelques mm³ à plusieurs centaines de dm³, et, de préférence, de quelques cm³ à 100 cm³.

Dans le mode de réalisation illustré à les figures 2a et 2b, un seul élément magnétocalorique 110 est utilisé. Selon une variante de réalisation, le dispositif de refroidissement 100 peut comprendre plusieurs éléments magnétocaloriques (deux, trois ou quatre par exemple), disposés en série ou en parallèle. Les différents éléments magnétocaloriques peuvent être séparés par des interrupteurs thermiques 140. Il est alors possible d'obtenir de plus forts écarts de température, ou d'obtenir un étage continu à une température intermédiaire.

A titre illustratif, la figure 3 représente un dispositif 100 avec deux étages d'élément magnétocalorique 110a et 110b disposés en séries, et comprenant deux interrupteurs thermiques à gaz d'échange 140. Un tel dispositif 100 peut permettre d'obtenir une grande différence de température avec, par exemple, le premier élément 110a permettant d'obtenir un refroidissement entre 4 K et 1,2 K et le deuxième élément 110b permettant d'obtenir un refroidissement entre 1,2 K et 0,4 K. Ce dispositif permet aussi d'obtenir un refroidissement continu par exemple à 400 mK de puissance de l'ordre de 50 µW. La figure 4 représente la courbe de température en fonction du temps correspondant à un tel dispositif. La température de la source chaude 120 et des éléments paramagnétiques 110a et 110b montés en série est représentée en fonction des cycles aimantation/désaimantation. Ainsi, la température de l'élément paramagnétique 110b, situé côté source froide 121, est maintenue constante à la température froide voulue. La température de l'élément paramagnétique 110a, situé côté source chaude 120, alterne entre une température plus chaude que la source chaude 120, permettant un transfert de chaleur vers celle-ci et une température plus faible que la source froide 121 permettant d'extraire de la chaleur de l'élément paramagnétique.

Ce dispositif de refroidissement 100 peut être complété par d'autres étages de refroidissement de type ADR, les autres étages pouvant comprendre, indépendamment les uns des autres, une céramique de grenat ou un autre matériau magnétocalorique, pas forcément sous forme céramique, pour apporter, en plus, un refroidissement sous les 200 mK.

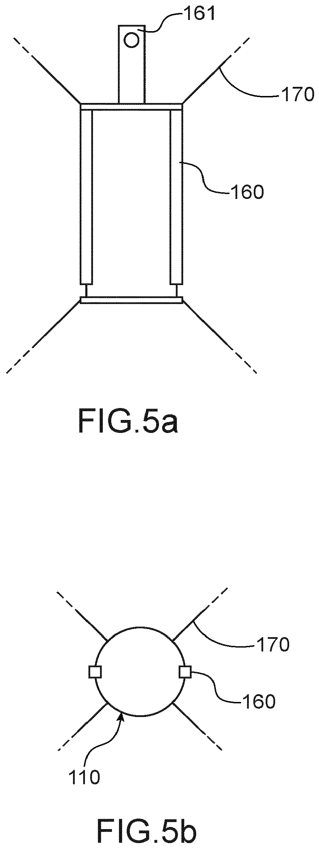

Selon un mode de réalisation avantageux, représenté sur les figures 5a et 5b, au moins un élément métallique thermiquement conducteur 160 est fixé sur l'élément magnétocalorique 110 pour améliorer la conductivité thermique. Il s'agit d'un élément ayant une forte conductivité thermique qui permet d'assurer les échanges thermiques entre les interfaces (élément à refroidir et source chaude) et l'élément magnétocalorique 110. Cet élément est également appelé bus thermique.

Le bus thermique 160 peut être sous la forme de fils. Il peut également s'agir d'une plaque. Dans tous les cas, le bus thermique présente au moins une interface 161 vers laquelle il sera thermiquement connecté (vers la source chaude 120 ou vers le dispositif à refroidir (source froide 121)). L'élément thermiquement conducteur peut être du cuivre ou de l'acier inoxydable par exemple.

Selon une première variante, l'élément métallique 160 est collé sur l'élément magnétocalorique 110, avec par exemple une colle de type époxy conductrice (Stycast par exemple).

Selon une autre variante particulièrement avantageuse, l'élément métallique 160 est brasé sur l'élément magnétocalorique 110.

Dans une variante, on peut tout à fait envisager de disposer un ou plusieurs éléments métalliques à l'intérieur de la céramique.

L'élément magnétocalorique 110 peut être maintenu par des moyens de suspension, thermiquement isolants 170, typiquement des fils de kevlar, ou des tubes de fibre de carbone apte à fixer ledit élément à un support mécanique non représenté.

### Interrupteur thermique :

Selon un mode de réalisation particulier, le dispositif ADR comprend, en outre, au moins un interrupteur thermique 140 (ou clapet), disposé entre la source froide chaude 120 et l'élément paramagnétique 110 et/ou entre la source chaude 121 et l'élément paramagnétique 110. Les interrupteurs thermiques sont, par exemple, des interrupteurs à gaz d'échange.

Comme représentés sur les figures 2a et 3, les interrupteurs thermiques 140 sont disposés entre les sources chaude 120 et froide 121. L'interrupteur dit chaud est situé entre la source chaude 120 et l'élément paramagnétique 110. L'interrupteur dit froid est situé entre la source froide 121 et l'élément paramagnétique 110. Pendant la désaimantation adiabatique et pendant l'aimantation adiabatique, les interrupteurs chaud et froid sont fermés. Pendant la désaimantation isotherme, l'interrupteur chaud est ouvert et l'interrupteur froid est fermé. Pendant, l'aimantation isotherme, l'interrupteur chaud est fermé et l'interrupteur froid est ouvert.

Selon une autre variante de réalisation, représentée sur la figure 2a, la partie à refroidir, par exemple un détecteur, est thermiquement liée à l'élément paramagnétique et il n'y a pas besoin d'interrupteur froid. Le dispositif comprend un seul interrupteur thermique 140 : l'interrupteur chaud.

Pour certaines applications, les interrupteurs thermiques 140 peuvent être remplacés par un fluide dit fluide de cycle qui peut circuler autour et/ou à travers du matériau paramagnétique. Ce mode de réalisation est avantageux pour obtenir de fortes puissances et/ou pour réaliser des cycles rapides avec des échanges thermiques importants.

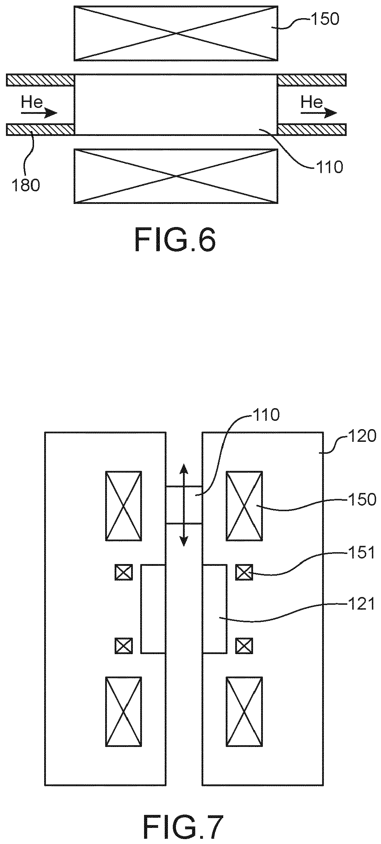

Pour confiner le fluide, une enveloppe 180, par exemple, en acier inoxydable est, avantageusement, fixée sur l'élément magnétocalorique 110 (figure 6). Elle peut être fixée, par collage ou, de préférence, par brasure.

Par exemple pour un dispositif de type AMRR, les étapes d'aimantation et de désaimantation sont alternées, avec la mise en place d'un débit de fluide qui traverse le matériau paramagnétique, dans un sens puis dans l'autre de manière à créer un gradient thermique à l'intérieur du matériau paramagnétique. Les quatre étapes sont les suivantes : aimantation adiabatique, débit de fluide du chaud vers le froid, désaimantation adiabatique, débit de fluide du froid vers le chaud.

### Générateur de champ :

L'élément magnétique 110 et le générateur de champ 150 sont positionnés et configurés de manière à soumettre l'élément paramagnétique 110 à un champ magnétique permettant de produire de la chaleur ou du froid, selon les cycles d'aimantation/désaimantation. Plus particulièrement, il est possible de provoquer successivement, et de manière cyclique, une désaimantation adiabatique, une désaimantation isotherme, une aimantation adiabatique et finalement une aimantation isotherme de l'élément paramagnétique 110.

Ce générateur de champ 150 peut être formé de tout élément susceptible de créer un champ magnétique variable. Par exemple, il peut s'agir d'une bobine de fil conducteur ou d'un ou plusieurs aimants permanents aptes à être déplacés relativement à l'élément paramagnétique 110.

Des moyens d'écrantage magnétique 130 peuvent entourer le générateur de champ 150, afin de limiter les champs magnétiques parasites à l'extérieur du dispositif.

Selon un premier mode de réalisation, la position de l'élément paramagnétique est fixe par rapport au générateur de champ et le champ magnétique est variable (figures 2 et 3).

Selon un autre mode de réalisation, la position de l'élément paramagnétique 110 varie par rapport au générateur de champ 150 et le champ magnétique est fixe (figures 7). De préférence, le dispositif 100 comprend deux générateurs de champs fixes entre lesquels se déplace alternativement le matériau paramagnétique. Des générateurs de champs faibles 151 peuvent être ajoutés dans le dispositif. Le dispositif ne comprend pas d'interrupteur thermique ; le dispositif de refroidissement peut utiliser des flux d'hélium alternés.

Selon un autre mode de réalisation, non représenté, la position de l'élément paramagnétique est fixe par rapport au générateur de champ et le champ magnétique est fixe. Il n'y a pas d'interrupteur thermique, on joue sur la gravité et les différents régimes de convection ou de condensation.

Le générateur de champ 150 comprend, par exemple, un élément magnétique destiné à générer le champ magnétique.

Le générateur de champ 150 est, par exemple, une bobine supraconductrice.

### Source chaude et source froide :

L'élément magnétocalorique 110 est thermiquement connecté à la source chaude 120 et à la source froide 121.

Avantageusement, la source froide 121 et la source chaude 120 sont disposées le long d'un même axe. Selon une variante, la source froide 121 et la source chaude 120 peuvent être disposées de façon quelconque.

Avantageusement, la source chaude 120 et la source froide 121 sont disposées dans l'environnement immédiat de l'élément magnétocalorique 110 de manière à récupérer facilement et /ou rapidement au moins une partie de la chaleur et/ou du froid qu'il émet. Ils peuvent former un circuit de fluide caloporteur.

On utilise, avantageusement, comme source chaude 120 et comme source froide 121 de l'hélium. Avantageusement, l'hélium est un mélange de liquide et de gaz à des pressions et températures différentes pour la source froide 121 et la source chaude 120.

Le dispositif de réfrigération peut, en outre, comprendre :
- des moyens de circulation du fluide,
- une alimentation électrique, par exemple, asservie par une unité de commande,
- un capteur thermique pour déterminer la température du fluide caloporteur.

Le dispositif de refroidissement 100 peut être utilisé pour des applications de fortes puissances (100 mW à plusieurs kW) ou de réfrigération à température ambiante.

Le dispositif de refroidissement 100 peut également être utilisé pour des applications spatiales : des refroidisseurs sous 100 mK et/ou un étage vers 400 mK peuvent être ajoutés pour des missions d'astrophysiques.

Pour des applications terrestres, le même matériau magnétocalorique en céramique de grenat serait également particulièrement adapté car, en plus de présenter un faible coût, et d'être facilement intégrable, il permet un refroidissement à des températures sous le Kelvin. Il peut également être utilisé pour des études sur l'électronique quantique.

### Procédé d'élaboration de la céramique de grenat :

Le procédé d'élaboration d'une céramique de grenat comprend plusieurs étapes :
a) synthèse d'une poudre fine de précurseurs, par exemple par réaction en phase solide,
b) broyage fin de la poudre de précurseurs,
c) mise en forme du matériau, par exemple sous forme d'un barreau, le matériau non fritté, ayant une densité inférieure à 70%, de préférence de 55% à 65%, par exemple de l'ordre de 60% (pièce à cru),
d) traitement thermique de la pièce à cru en dessous de la température de fusion du matériau pour obtenir une céramique frittée de densité voulue.

Les particules broyées de la poudre synthétisée ont, avantageusement, un diamètre inférieur à 10µm, de préférence de 1µm à 7µm et encore plus préférentiellement de 3µm à 5µm. De tels diamètres facilitent l'obtention d'un matériau dense à la fin du procédé. Les particules formant la poudre sont, avantageusement, monodisperses.

Lors de l'étape c), les particules sont compactées.

Durant l'étape de frittage (étape d), le matériau est chauffé en dessous de la température de fusion pour faire coalescer les grains, réduire la porosité interne et ainsi densifier le matériau.

Plus particulièrement, lors du frittage, certains grains coalescent entre eux pour devenir des grains plus gros en réduisant l'espace libre entre les grains de départ, ce qui augmente la densité. Des « cous » se forment entre les grains et il y a une interpénétration des grains jusqu'à obtenir une suppression quasi-complète des porosités ouvertes et fermées. Lors du frittage, une majorité de pores se bouchent, mais quelques espaces de gaz résiduels persistent : la céramique a une densité strictement inférieure à 100%.

Au final, la céramique est formée d'un ensemble de grains de tailles différentes. Une première partie des grains (les plus gros grains) est coalescée et l'autre partie des grains (les plus petits grains) n'est pas ou très peu coalescée.

On choisira les paramètres du procédé de manière à obtenir, par exemple, une densité la plus proche possible de 100%, et de préférence supérieure à 95%.

La température de frittage dépend de la méthode de préparation de la poudre, de la taille des particules et, éventuellement, des adjuvants qui peuvent être ajoutées. Classiquement, la température de frittage peut être évaluée par dilatométrie.

### Exemple illustratif et non limitatif d'un mode de réalisation :

Une céramique d'YbGG est obtenue à partir de poudres de Ga₂O₃ et de Yb₂O₃.

Les poudres sont broyées et mélangées à l'aide d'un broyeur planétaire (bol et billes d'oxyde de Zircone). La présynthèse est réalisée dans un creuset d'alumine à 1050°C sous air. La mise en forme est obtenue par pressage isostatique dans une vessie en caoutchouc naturel à 2500 bars. La température finale du traitement thermique est de 1700°C sous air (température inférieure à la température de fusion du composé YbGG).

Le matériau ainsi élaboré présente une densité finale supérieure à 95%, une taille de grain réduite lui conférant de bonnes propriétés mécaniques et une conduction thermique optimisée.

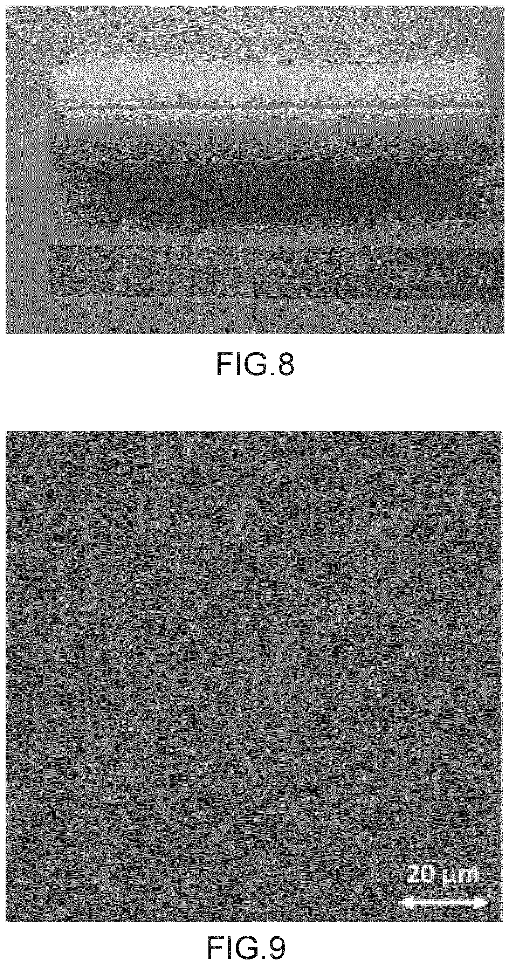

La céramique d'YbGG obtenue est un cylindre de 50 cm³ (figures 8 et 9).

La céramique de grenat est placée dans une bobine supraconductrice. La source chaude est à 2 Kelvin et le refroidissement se fait à 400 mK.

Une céramique de grenat paramagnétique telle que décrite précédemment pourrait aussi être utilisée dans un dispositif de chauffage.

## Revendications

1. Dispositif de refroidissement magnétique (100) comportant un élément magnétocalorique (110), l'élément magnétocalorique (110) comprenant un grenat paramagnétique, **caractérisé en ce que** le grenat paramagnétique est une céramique.

2. Dispositif selon la revendication précédente, **caractérisé en ce que** la céramique est formée de grains ayant différentes dimensions, les grains étant séparés par des joints de grains, les joints de grains délimitant des zones ayant différentes orientations cristallines.

3. Dispositif selon l'une des revendications précédentes, **caractérisé en ce que** la céramique a une densité supérieure à 80% et strictement inférieure à 100%.

4. Dispositif selon l'une des revendications précédentes, **caractérisé en ce que** la céramique a une densité supérieure ou égale à 90% et strictement inférieure à 100%.

5. Dispositif selon l'une des revendications précédentes, **caractérisé en ce que** la céramique a une densité supérieure ou égale à 95% et strictement inférieure à 100%.

6. Dispositif selon l'une quelconque des revendications précédentes, **caractérisé en ce que** l'élément magnétocalorique (110) est constitué de la céramique de grenat paramagnétique.

7. Dispositif selon l'une quelconque des revendications précédentes, **caractérisé en ce que** la céramique contient du gallium.

8. Dispositif selon la revendication 7, **caractérisé en ce que** la céramique est une céramique de grenat de gallium gadolinium.

9. Dispositif selon la revendication 7, **caractérisé en ce que** la céramique est une céramique de gallium ytterbium.

10. Dispositif selon l'une quelconque des revendications précédentes, **caractérisé en ce que** l'élément magnétocalorique (110) a un volume allant de 1mm³ à 500dm³.

11. Dispositif selon l'une quelconque des revendications précédentes, **caractérisé en ce que** l'élément magnétocalorique (110) a un volume allant de 1cm³ à 100cm³.

12. Dispositif selon l'une quelconque des revendications précédentes, **caractérisé en ce que** l'élément magnétocalorique (110) est solidaire d'un élément métallique.

13. Dispositif selon la revendication 12, **caractérisé en ce que** l'élément métallique est collé sur l'élément magnétocalorique (110).

14. Dispositif selon la revendication 12, **caractérisé en ce que** l'élément métallique est brasé sur l'élément magnétocalorique (110).

15. Dispositif selon l'une des revendications 12 à 14, **caractérisé en ce que** l'élément métallique est un bus thermique (160) ou une enveloppe (180).
